# EUROPEAN PATENT SPECIFICATION

(11) **EP 2 688 193 B1**
(45) Date of publication and mention of the grant of the patent: **27.04.2016**
(21) Application number: 12757112.3
(22) Date of filing: 01.02.2012
(51) Int. Cl.: H02N 11/00, H01L 35/28, H01L 35/30, H01L 35/32

(54) **THERMOELECTRIC GENERATOR DEVICE AND PORTABLE ELECTRONIC APPARATUS**
THERMOELEKTRISCHE GENERATORVORRICHTUNG UND TRAGBARE ELEKTRONISCHE VORRICHTUNG
DISPOSITIF GÉNÉRATEUR THERMOÉLECTRIQUE ET APPAREIL ÉLECTRONIQUE PORTABLE

(30) Priority: 17.03.2011 JP 2011059369
(43) Date of publication of application: 22.01.2014
(73) Proprietor: FUJIFILM Corporation, Tokyo 106-0031 (JP)
(72) Inventor: HAYASHI Naoyuki, Kanagawa (JP); NISHIO Ryo, Kanagawa (JP); AOAI Toshiaki, Kanagawa (JP)
(74) Representative: Hoffmann Eitle
(86) International application number: PCT/JP2012/052269
(87) International publication number: WO 2012/124394

(56) References cited:
- EP-A2- 1 202 356
- WO-A1-2009/063805
- DE-A1- 3 807 633
- JP-A- 11 284 235
- JP-A- H11 284 235
- JP-A- 2000 014 026
- JP-A- 2006 210 568

## Description

### Technical Field

The present invention relates to a thermoelectric power generation device and a portable electronic apparatus.

### Background Art

Portable electronic apparatuses such as cellular phones, notebook personal computers and portable music players have come into wide use recently. Normally, these portable electronic apparatuses are operated by small-sized secondary batteries such as lithium-ion batteries or nickel-metal hydride batteries.

Therefore, in order to use these portable electronic apparatuses, an operation of charging the second batteries is required. Chargers having a function of rectifying AC power sources and regulating the rectified AC power sources to predetermined DC voltages are necessary for the charging. For this reason, there is a restriction on places where electric power is consumed to perform the charging operation.

A thermoelectric charger integrated type secondary battery which has a thermoelectric conversion element formed in an outer surface side of a housing of a cellular phone and a secondary battery formed integrally in a surface of the thermoelectric conversion element opposite to the outer surface of the housing of the cellular phone to store electric energy obtained by electric power generated by the thermoelectric conversion element has been proposed as a secondary battery which can be charged without use of any AC power source (see Patent Literature 1, JP-A-11-284235).

According to the portable apparatus using the thermoelectric charger integrated type secondary battery, a charging operation using a charger is unnecessary and a power source can be dispensed with so that power consumption at the time of charging can be eliminated.

In addition, a semiconductor device which has a silicon substrate, a thermoelectric conversion element formed in a front surface of the silicon substrate and an LSI formed in a rear surface of the silicon substrate has been described in Patent Literature 2, JP-A-2007-95897. This semiconductor device is designed so that heat generated in the LSI is converted into electric power by the thermoelectric conversion element and the electric power can be stored by a capacitor contained in the LSI.

In addition, technology in which a thermoelectric conversion element and a circuit element connected thereto are provided in the front and rear with respect to a substrate has been disclosed in Patent Literature 3, JP-A-2010-283130.

In the thermoelectric charger integrated type secondary battery described in Patent Literature 1, it is necessary to connect the thermoelectric conversion element and the secondary battery to each other by wiring of a metal or the like which conducts heat. Therefore, heat on a high temperature side of the thermoelectric conversion element is conducted to a secondary battery side through this wiring. Since the temperature of the secondary battery is increased by the conducted heat, there is a possibility that a temperature difference between the low temperature side and the high temperature side of the thermoelectric power generation element may become small to thereby weaken a power generation effect or shorten the life of the secondary battery. No consideration about such a possibility has been given in Patent Literature 1.

No consideration about the aforementioned possibility caused by conduction of heat to the circuit element has been given in Patent Literatures 2 and 3.

### Summary of Invention

Reference is made to DE 38 07 633 A1. The two-part form adopted in the independent claim below is based on this document.

The invention has been accomplished in consideration of the aforementioned circumstances. An object of the invention is to provide a thermoelectric power generation device which can achieve compactness, long life and high power generation efficiency, and a portable electronic apparatus equipped with the thermoelectric power generation device.

The thermoelectric power generation device according to the invention is a thermoelectric power generation device having a substrate, and a thermoelectric conversion element formed on one surface of the substrate, wherein: the thermoelectric conversion element is formed so that the one surface side is used as a low temperature side; and the thermoelectric power generation device further has: an electric storage circuit which is formed on the other surface of the substrate to store electric energy generated by the thermoelectric conversion element; a first wiring which is a wiring formed on the other surface of the substrate to electrically connect the thermoelectric conversion element and the electric storage circuit to each other; and a heat radiation fin which is disposed above the other surface of the substrate to cover the first wiring in plan view.

According to the configuration, the thermoelectric conversion element and the electric storage circuit are formed on one surface and the other surface of the substrate respectively, so that the thermoelectric power generation device can be made compact. Moreover, the first wiring which connects the electric storage circuit and the thermoelectric conversion element to each other is formed on the other surface of the substrate and the heat radiation fin is disposed to cover the first wiring, so that heat transmitted from the one surface side of the substrate to the electric storage circuit through the first wiring can be diffused efficiently by the heat radiation fin. As a result, the temperature of the electric storage circuit can be prevent from increasing, so that power generation efficiency can be improved and the electric storage circuit can be long-lived.

The portable electronic apparatus according to the invention is a portable electronic apparatus equipped with the thermoelectric power generation device, wherein: the portable electronic apparatus has an element which generates heat by consumption of electric power; and a high temperature side of the thermoelectric conversion element included in the thermoelectric power generation device is disposed to face the element.

According to the configuration, the portable electronic apparatus which is chargeable without use of any charger can achieve compactness, long life and long-term use in a remote place without power supply by reduction in number of charging times.

### Effects of Invention

According to the invention, it is possible to provide a thermoelectric power generation device which can achieve compactness, long life and high power generation efficiency, and a portable electronic apparatus equipped with the thermoelectric power generation device.

### Brief Description of Drawings

[Fig. 1] A schematic plan view of a thermoelectric power generation device from a front side for explaining an embodiment of the invention.
[Fig. 2] A schematic plan view of the thermoelectric power generation device from a rear side for explaining the embodiment of the invention.
[Fig. 3] A schematic sectional view taken along a line A-A shown in Fig. 2.
[Fig. 4] A view showing details of an electric storage circuit shown in Fig. 2.
[Fig. 5] A view showing a modification of the shape of heat radiation fins 7 of the thermoelectric power generation device 100 shown in Fig. 1.
[Fig. 6] A schematic sectional view showing the schematic configuration of a cellular phone which is an example of a portable electronic apparatus equipped with the thermoelectric power generation device 100 shown in Figs. 1 to 3.

### Embodiments for Carrying Out the Invention

An embodiment of the invention will be described below with reference to the drawings.

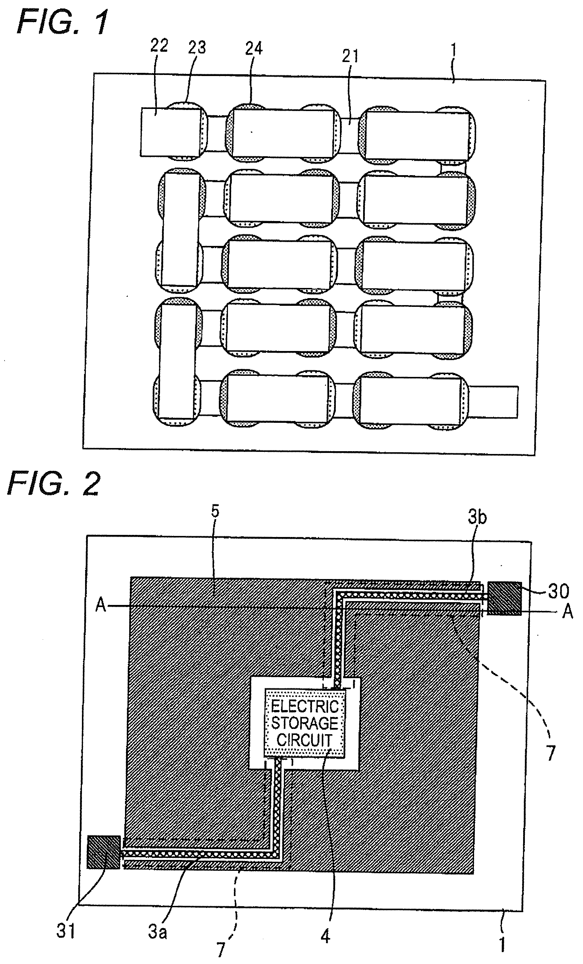

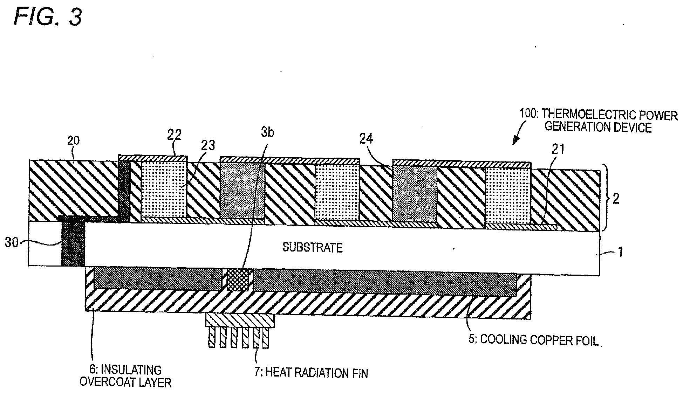

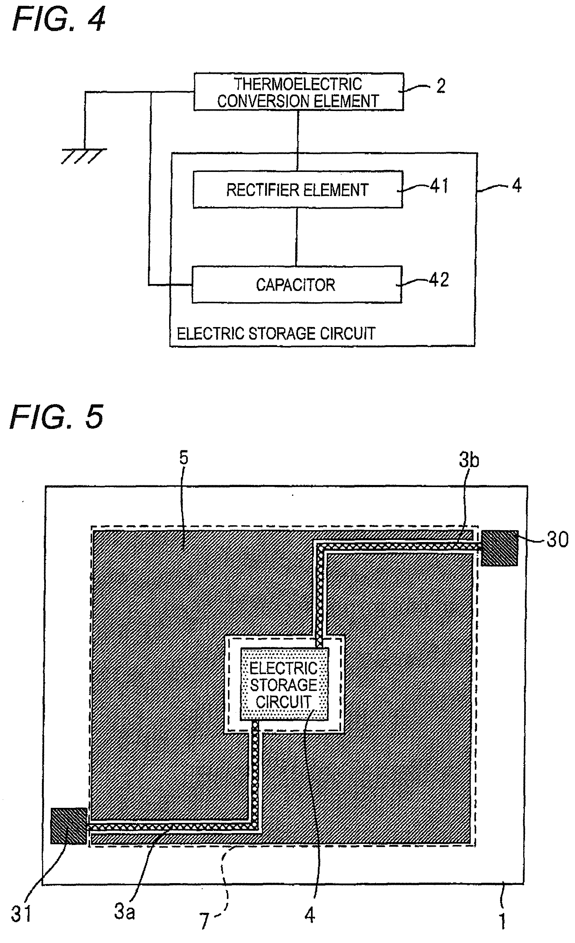

Fig. 1 is a schematic plan view of a thermoelectric power generation device from a front side for explaining an embodiment of the invention. Fig. 2 is a schematic plan view of the thermoelectric power generation device from a rear side for explaining the embodiment of the invention. Fig. 3 is a schematic sectional view taken along a line A-A shown in Fig. 2. Fig. 4 is a view showing details of an electric storage circuit shown in Fig. 2.

As shown in Figs. 1 to 3, the thermoelectric power generation device 100 has a substrate 1, a thermoelectric conversion element 2, an electric storage circuit 4, wirings 30, 31, 3a and 3b, a metal film 5, an insulating overcoat layer 6, and heat radiation fins 7. The substrate 1 is made of glass epoxy, polyimide, liquid crystal polymer (LCP), solder resist, or the like. The thermoelectric conversion element 2 is formed on a front surface which is one surface of the substrate 1. The electric storage circuit 4 is formed on a rear surface which is the other surface of the substrate 1. The wirings 30, 31, 3a and 3b are made of a conductive material such as metal for electrically connecting the thermoelectric conversion element 2 and the electric storage circuit 4 to each other. The metal film 5 is formed on the rear surface of the substrate 1 and provided for cooling the substrate 1. The insulating overcoat layer 6 is made of polyimide, polysiloxane, SiO₂, or the like, to cover the electric storage circuit 4, the wirings 3a and 3b and the metal film 5. The heat radiation fins 7 are formed on the overcoat layer 6.

As shown in Fig. 1 and Fig. 3, the thermoelectric conversion element 2 has a plurality of lower electrodes 21 which are formed on the front surface of the substrate 1 so as to be separated from one another, p-type semiconductors 23 (for example, BiSbTe, Na₂Co₂O₄, MnSi, FeSi₂, CoSb₃, Zn₄Sb₃, etc.) and n-type semiconductors 24 (for example, Bi₂Te₃, BiSeTe, Mg₂Si, ZnAlO (AZO) etc.) which are embedded into openings formed in an insulating layer 20 formed on the lower electrodes 21 and the front surface of the substrate 1, and a plurality of upper electrodes 22 which are formed on the insulating layer 20, the p-type semiconductors 23 and the n-type semiconductors 24 so as to be separated from one another. Any well-known p-type semiconductor material and n-type semiconductor material described in "Present State and Trend of Thermoelectric Conversion Technology" (Idemitsu Giho, Vol. 47, No. 2, 2004) can be used as thermoelectric conversion materials.

As shown in Figs. 1 and 3, the upper electrodes 22, the p-type semiconductors 23, the lower electrodes 21 and the n-type semiconductors 24 are connected like a chain. The p-type semiconductors 23 sandwiched between the upper electrodes 22 and the lower electrodes 21, and the n-type semiconductors 24 sandwiched between the upper electrodes 22 and the lower electrodes 21 are arranged alternately two-dimensionally. The p-type semiconductors 23 and the n-type semiconductors 24 are electrically connected in series.

The wirings 30 and 31 (see Figs. 2 and 3) are connected to opposite ends of this series connection respectively, that is, to the upper electrode 22 located on an upper left end and the lower electrode 21 located on a lower right end in Fig. 1. These two wirings 30 and 31 are exposed from the rear surface of the substrate 1 through hole portions (contact holes) which are formed to penetrate the substrate 1 from the front surface to the rear surface.

In the thermoelectric conversion element 2, an upper electrode 22 side is used as a high temperature side while a lower electrode 21 side (the front side of the substrate 1) is used as a low temperature side. The thermoelectric conversion element 2 generates electric energy in accordance with a temperature difference between the upper electrodes 22 and the lower electrodes 21. Incidentally, any widely known configuration may be used for the thermoelectric conversion element 2 but the thermoelectric conversion element 2 is not limited to the configuration shown in Fig. 1.

As shown in Fig. 2, the electric storage circuit 4 which stores electric energy generated by the thermoelectric conversion element 2 is formed in the center of the rear surface of the substrate 1.

The wiring 30 which is a wiring connected to the upper electrode 22 located at the upper left end in Fig. 1 and which is embedded in the contact hole penetrating the substrate 1 is exposed at an upper right end of the substrate 1 in Fig. 2.

The wiring 31 which is a wiring connected to the lower electrode 21 located at the lower right end in Fig. 1 and which is embedded in the contact hole penetrating the substrate 1 is exposed at a lower left end of the substrate 1 in Fig. 2.

In addition, the wiring 3b connecting the wiring 30 and the electric storage circuit 4 to each other and the wiring 3a connecting the wiring 31 and the electric storage circuit 4 to each other are formed on the rear surface of the substrate 1.

The metal film 5 is formed around the electric storage circuit 4 and the wirings 3a and 3b so as not to come into contact therewith. The metal film 5 is provided for cooling the substrate 1 being in contact with the lower electrodes 21 used as the low temperature side of the thermoelectric conversion element 2. The metal film 5 is a film made of a metal material which can cool the substrate 1. For example, the metal film 5 is made of copper.

The metal film 5 is formed in such a manner that, for example, copper is formed into a film on the rear surface of the substrate 1 and the copper film is then selectively etched.

A region from which the copper film has been removed by etching exists in the central portion of the substrate 1. The electric storage circuit 4 is formed on the rear surface of the substrate 1 exposed from this region.

In addition, the copper film is also removed by etching from regions which extend from the region of the central portion from which the copper film has been removed by etching to the wirings 30 and 31 and each of which is formed like an L-figure. The wirings 3a and 3b are formed in these regions. Since the wirings 3a and 3b can be made of metal, the wirings 3a and 3b can be formed by the same process as that of the metal film 5.

As shown in Fig. 4, the electric storage circuit 4 includes a capacitor 42 which stores electric energy generated by the thermoelectric conversion element 2, and a rectifier element 41 which is made of a diode or the like for preventing a reverse current from being applied (preventing a current from flowing back) from the capacitor 42 to the thermoelectric conversion element 2.

The capacitor 42 includes an electrode connected to the wiring 3a, an electrode connected to the wiring 3b, and a dielectric sandwiched between these two electrodes.

The rectifier element 41 is connected between the wiring 3a or the wiring 3b and the capacitor 42. Incidentally, the rectifier element 41 can be dispensed with.

As shown Figs. 2 and 3, the heat radiation fins 7 are formed in positions (paths where the wirings 3a and 3b are formed) where the heat radiation fins 7 can cover the wirings 3a and 3b and boundary portions between the wirings 3a and 3b and the metal film 5 in plan view.

Heat on the front side of the substrate 1 is transmitted to the electric storage circuit 4 through the wirings 30 and 31 in the contact holes formed in the substrate 1 and through the wirings 3a and 3b connected to the wirings 30 and 31. In addition, the wirings 3a and 3b need to be formed so as to be spaced to ensure insulation from the metal film 5. In this manner, the wirings 3a and 3b can hardly receive a heat radiation effect from the metal film 5.

Therefore, when the heat radiation fins 7 are disposed to cover the wirings 3a and 3b serving as heat transmitting sources and gaps between the wirings 3a and 3b and the metal film 5, heat of the wirings 3a and 3b is reduced by heat radiation from the heat radiation fins 7 and heat conduction between the wirings 3a and 3b and the metal film 5 through the heat radiation fins 7 so that the heat transmitted from the front side of the substrate 1 to the electric storage circuit 4 can be reduced.

Because the heat transmitted to the electric storage circuit 4 formed on the rear surface of the substrate 1 is reduced, a temperature difference between the high temperature side and the low temperature side of the thermoelectric conversion element 2 can be enlarged so that power generation efficiency can be improved. In addition, life extension of the electric storage circuit 4 can be achieved.

Incidentally, the heat radiation fins 7 may be disposed in regions which overlap at least the wirings 3a and 3b in plan view. When the heat radiation fins 7 are disposed in regions which cover the wirings 3a and 3b and the boundary portions between the wirings 3a and 3b and the metal film 5, a heat radiation effect can be enhanced compared with the case where the heat radiation fins 7 are disposed only in regions which overlap the wirings 3a and 3b.

Moreover, as shown in Fig. 5, the heat radiation fins may be disposed to cover the whole of the metal film 5 when seen from the rear surface of the substrate 1. When the heat radiation fins are disposed thus, a heat radiation effect can be further enhanced.

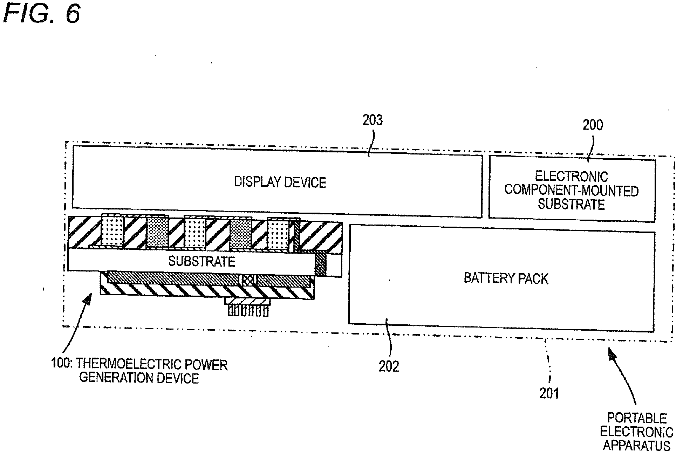

Fig. 6 is a schematic sectional view showing the schematic configuration of a portable electronic apparatus, such as a cellular phone or a digital camera, equipped with the thermoelectric power generation device 100 shown in Figs. 1 to 3.

The portable electronic apparatus shown in Fig. 6 has an electronic component-mounted substrate 200, a battery pack 202, the thermoelectric power generation device 100 shown in Figs. 1 to 3, and a display device 203 all of which are enclosed in a housing 201.

The electronic component-mounted substrate 200 is a substrate which is disposed on a front side of the housing 201 and which has various built-in circuits for achieving functions necessary for the portable electronic apparatus.

The display device 203 is disposed on the front side of the housing 201 and provided for displaying various kinds of information. The display device 203 includes a liquid crystal display panel, an organic EL panel, etc. In operation, the temperature of a rear portion of the display device 203 is increased by heat generated in the backlight for the liquid crystal display panel or in the organic EL panel.

The battery pack 202 is disposed on a rear side of the housing 201 (in the rear of the electronic component-mounted substrate 200 and the display device 203) to supply electric power to the electronic component-mounted substrate 200 and the display device 203. The battery pack 202 is connected to the capacitor 42 of the thermoelectric power generation device 100 by a not-shown wiring and charged with energy stored in the capacitor 42.

The thermoelectric power generation device 100 is disposed in the rear of the display device 203 so that the upper electrodes 22 (high temperature side) of the thermoelectric conversion element 2 face the display device 203.

A charging operation of the portable electronic apparatus configured as described above will be described.

When the display device 203 operates, the temperature of the rear portion of the display device 203 is increased by heat generated in the backlight for the liquid crystal display panel or in the organic EL panel. The heat in the rear portion of the display device 203 is transmitted from the housing 201 to the upper electrodes 22 of the thermoelectric conversion element 2, so that electric energy is generated in the thermoelectric conversion element 2.

The generated electric energy is stored in the capacitor 42 of the electric storage circuit 4 through the wirings 30 and 31 and the wirings 3a and 3b.

The electric energy stored in the capacitor 42 is supplied to the battery pack 202, so that rechargeable batteries are charged with the energy.

In this manner, according to the portable electronic apparatus shown in Fig. 6, the charging operation can be performed by the heat generated during the operating time of the display device 203 of the portable electronic apparatus without use of any charger attached to the portable electronic apparatus.

There is a possibility that the heat of the display device 203 will be transmitted to the electric storage circuit 4 through the wirings 3a and 3b connected to the thermoelectric conversion element 2 during the operating time of the display device 203 of the portable electronic apparatus. However, since the portable electronic apparatus shown in Fig. 5 is equipped with the thermoelectric power generation device 100 shown in Figs. 1 to 3, the heat transmitted from the display device 203 can be radiated (cooled) efficiently by the heat radiation fins 7.

Accordingly, the power generation efficiency of the thermoelectric conversion element 2 can be prevented from being lowered due to warming up of the electric storage circuit 4 and the electric storage circuit 4 can be prevented from being deteriorated due to heating up of the electric storage device 4.

In addition, since the heat radiation fins 7 may be provided in any regions as long as the heat radiation fins 7 can overlap the wirings 3a and 3b and the boundary portions between the wirings 3a and 3b and the metal film 5 in the thermoelectric power generation device 100, the area occupied by the heat radiation fins 7 relative to the whole of the thermoelectric power generation device 100 is so small that the thermoelectric power generation device 100 can be made compact.

Incidentally, the thermoelectric power generation device 100 may be mounted in any portable electronic apparatus which is not limited to a cellular phone or a digital camera but may be an electrically operated apparatus such as a wristwatch, a game machine, a portable music player or a notebook personal computer.

In addition, any component or element which generates heat by consuming electric power of a display device, a DC-DC converter and a display element drive IC or the like can be used as the heat source in the portable electronic apparatus. Particularly, the display device is preferred as the heat source for thermoelectric power generation because the display device has a large installation area and generates a large quantity of heat.

Incidentally, when the portable electronic apparatus is a digital camera, the thermoelectric power generation device 100 may be disposed in the rear of an imaging element which is an element generating heat by consuming electric power so that the side of the upper electrodes 22 of the thermoelectric power generation device 100 faces the side of the imaging element. In this manner, heat generated from the imaging element can be converted into electric energy with which charging can be performed. Thus, a digital camera chargeable during imaging can be attained.

The thermoelectric power generation device 100 is compact because the thermoelectric conversion element 2 and the electric storage circuit 4 are formed integrally in the front and rear of the substrate 1 respectively. Accordingly, the thermoelectric power generation device 100 is preferred as a device mounted in a portable electronic apparatus. Moreover, the thermoelectric power generation device 100 is compact but has a configuration in which heat conduction to the electric storage circuit 4 is suppressed effectively by the heat radiation fins 7. Therefore, the life of the portable electronic apparatus can be made longer and power generation efficiency can be improved.

Incidentally, an insulating film may be provided between the substrate 1 and the thermoelectric conversion element 2 in the thermoelectric power generation device 100. In addition, another insulating film may be provided between the metal film 5 with the wirings 3a and 3b and the rear surface of the substrate 1. These insulating films may be so thick as not to impede reduction in thickness of the thermoelectric power generation device 100. In addition, when these insulating films are provided, a semiconductor substrate made of silicon or the like may be used as the substrate 1.

As described above, the following items are disclosed in this specification.

The disclosed thermoelectric power generation device is a thermoelectric power generation device having a substrate, and a thermoelectric conversion element formed on one surface of the substrate, wherein: the thermoelectric conversion element is formed so that the one surface side is used as a low temperature side; and the thermoelectric power generation device further has: an electric storage circuit which is formed on the other surface of the substrate to store electric energy generated by the thermoelectric conversion element; a first wiring which is a wiring formed on the other surface of the substrate to electrically connect the thermoelectric conversion element and the electric storage circuit to each other; and heat radiation fins which are disposed above the other surface of the substrate to cover the first wiring in plan view.

According to the configuration, the thermoelectric conversion element and the electric storage circuit are formed on one surface and the other surface of the substrate respectively, so that the thermoelectric power generation device can be made compact. Moreover, the first wiring which connects the electric storage circuit and the thermoelectric conversion element to each other is formed on the other surface of the substrate and the heat radiation fins are disposed to cover the first wiring. Accordingly, heat transmitted from the one surface side of the substrate to the electric storage circuit through the first wiring can be diffused efficiently by the heat radiation fins. As a result, the temperature of the electric storage circuit can be prevented from increasing, so that power generation efficiency can be improved and the life of the electric storage circuit can be made longer.

The disclosed thermoelectric power generation device further has: a second wiring which is a wiring connected to the thermoelectric conversion element and which penetrates the substrate from the one surface to the other surface so as to be exposed in the other surface of the substrate; wherein: the first wiring is connected to the second wiring; and the exposed surface of the second wiring is disposed at an end portion of the substrate in plan view.

According to the configuration, the position where heat is transmitted from the one surface of the substrate to the other surface of the substrate can be set at the end portion of the substrate, so that a distance from the end portion of the substrate to the electric storage circuit can be made long. When the distance becomes long, the length of the first wiring can be made long. Accordingly, the time for which heat transmitted through the first wiring is diffused by the heat radiation fins can be made so long that heat transmission to the electric storage circuit can be more suppressed.

The disclosed thermoelectric power generation device further has: a metal film which is provided for cooling the substrate and which is formed around a region where the electric storage circuit and the first wiring on the other surface of the substrate are disposed; wherein: the heat radiation fins also cover a boundary between the first wiring and the metal film in plan view.

According to the configuration, the metal film is formed on the other surface of the substrate, so that the temperature on the rear surface side of the substrate can be made lower and power generation efficiency can be improved. In addition, the boundary portion between the metal film and the first electrode is covered with the heat radiation fins. Accordingly, the portion which cannot be cooled by the metal film can be cooled by the heat radiation fins, so that a cooling effect can be enhanced.

In the disclosed thermoelectric power generation device, the electric storage circuit has a capacitor which stores the electric energy, and a rectifier element for preventing a current from flowing back from the capacitor to the thermoelectric conversion element.

According to the configuration, the current can be prevented from flowing back from the capacitor to the thermoelectric conversion element, so that thermoelectric conversion efficiency can be prevented from being lowered.

The disclosed portable electronic apparatus is a portable electronic apparatus equipped with the thermoelectric power generation device, wherein: the portable electronic apparatus has an element which generates heat by consuming electric power; and a high temperature side of the thermoelectric conversion element included in the thermoelectric power generation device is disposed to face the element.

According to the configuration, the portable electronic apparatus chargeable without use of any charger can be made compact and long-lived.

### Industrial Applicability

According to the invention, it is possible to provide a thermoelectric power generation device which can achieve compactness, long life and high power generation efficiency, and a portable electronic apparatus equipped with the thermoelectric power generation device.

Although the invention has been described in detail and with reference to a specific embodiment, it is obvious to those skilled in the art that various changes and modifications may be made without departing from the scope of the invention. The present application is based on Japanese Patent Application (Patent Application 2011-59369) filed on March 17, 2011.

### Reference Signs List

- 1: substrate
- 2: thermoelectric conversion element
- 3a, 3b: wiring
- 4: electric storage circuit
- 5: metal film
- 7: heat radiation fin
- 30, 31: wiring
- 100: thermoelectric power generation device

## Claims

1. A thermoelectric power generation device (100) comprising:
a substrate (1) and a thermoelectric conversion element (2) formed on one surface of the substrate, the thermoelectric conversion element being formed so that the one surface side is used as a low temperature side; andan electric storage circuit (4) which is formed on other surface of the substrate to store electric energy generated by the thermoelectric conversion element; and
a first wiring (3a, 3b) which is a wiring formed on the other surface of the substrate to electrically connect the thermoelectric conversion element and the electric storage circuit to each other, **characterized by**:
a heat radiation fin (7) which is disposed above the other surface of the substrate to cover the first wiring in plan view.

2. The thermoelectric power generation device according to Claim 1, further comprising:
a second wiring (30, 31) which is a wiring connected to the thermoelectric conversion element and which penetrates the substrate from the one surface to the other surface so as to be exposed in the other surface of the substrate; wherein:
the first wiring is connected to the second wiring; and
the exposed surface of the second wiring is disposed at an end portion of the substrate in plan view.

3. The thermoelectric power generation device according to Claim 1 or 2, further comprising:
a metal film (5) which is provided for cooling the substrate and which is formed around a region where the electric storage circuit and the first wiring on the other surface of the substrate are disposed; wherein:
the heat radiation fin also covers a boundary between the first wiring and the metal film in plan view.

4. A portable electronic apparatus equipped with the thermoelectric power generation device according to any one of Claims 1 to 3, wherein:
the portable electronic apparatus comprises an element which generates heat by consumption of electric power; and
a high temperature side of the thermoelectric conversion element included in the thermoelectric power generation device is disposed to face the element.

## Patentansprüche

1. Thermoelektrische Energieerzeugungsvorrichtung (100), mit:
einem Substrat (1) und einem thermoelektrischen Umwandlungselement, das an einer Oberfläche des Substrats ausgebildet ist, wobei das thermoelektrische Umwandlungselement so ausgebildet ist, dass die eine Oberflächenseite als eine Niedertemperaturseite verwendet wird; und einem Elektrospeicherschaltkreis (4), welcher an einer anderen Oberfläche des Substrats ausgebildet ist, um durch das thermoelektrische Umwandlungselement erzeugte elektrische Energie zu speichern; und
einer ersten Verdrahtung (3a, 3b), welche eine Verdrahtung ist, die an der anderen Oberfläche des Substrats ausgebildet ist, um das thermoelektrische Umwandlungselement und den Elektrospeicherschaltkreis elektrisch miteinander zu verbinden, **gekennzeichnet durch**:
eine Wärmeabstrahlungsrippe (7), welche über der anderen Oberfläche des Substrats angeordnet ist, um die erste Verdrahtung in Draufsicht zu bedecken.

2. Thermoelektrische Energieerzeugungsvorrichtung nach Anspruch 1, ferner mit:
einer zweiten Verdrahtung (30, 31), welche eine mit dem thermoelektrischen Umwandlungselement verbundene Verdrahtung ist, und welche das Substrat von der einen Oberfläche zu der anderen Oberfläche durchdringt, um in der anderen Oberfläche des Substrats freiliegend zu sein; wobei:
die erste Verdrahtung mit der zweiten Verdrahtung verbunden ist; und
die freiliegende Oberfläche der zweiten Verdrahtung an einem Endabschnitt des Substrats in Draufsicht angeordnet ist.

3. Thermoelektrische Energieerzeugungsvorrichtung nach Anspruch 1 oder 2, ferner mit:
einem Metallfilm (5), welcher zum Kühlen des Substrats vorgesehen ist, und welcher um einen Bereich herum ausgebildet ist, wo der Elektrospeicherschaltkreis und die erste Verdrahtung an der anderen Oberfläche des Substrats angeordnet sind; wobei:
die Wärmeabstrahlungsrippe auch eine Grenze zwischen der ersten Verdrahtung und dem Metallfilm in Draufsicht bedeckt.

4. Tragbare elektronische Vorrichtung, die mit der thermoelektrischen Energieerzeugungsvorrichtung nach einem der Ansprüche 1 bis 3 ausgestattet ist, wobei:
die tragbare elektronische Vorrichtung ein Element aufweist, welches durch Verbrauch von elektrischer Energie Wärme erzeugt; und
eine Hochtemperaturseite des thermoelektrischen Umwandlungselements, das in der thermoelektrischen Energieerzeugungsvorrichtung enthalten ist, angeordnet ist, um dem Element zugewandt zu sein.

## Revendications

1. Dispositif de génération d'énergie thermoélectrique (100), comprenant :
un substrat (1) et un élément de conversion thermoélectrique (2) formé sur une surface du substrat,
l'élément de conversion thermoélectrique étant formé de sorte que la première surface soit utilisée comme côté basse température ; et un circuit de stockage électrique (4) qui est formé sur l'autre surface du substrat pour stocker l'énergie électrique générée par l'élément de conversion thermoélectrique ; et
un premier câblage (3a, 3b) qui est un câblage formé sur l'autre surface du substrat pour connecter électriquement l'élément de conversion thermoélectrique et le circuit de stockage électrique l'un à l'autre,
**caractérisé par** :
une ailette de rayonnement thermique (7) qui est disposée au-dessus de l'autre surface du substrat pour couvrir le premier câblage en vue en plan.

2. Dispositif de génération d'énergie thermoélectrique selon la revendication 1, comprenant en outre :
un second câblage (30, 31) qui est un câblage connecté à l'élément de conversion thermoélectrique et qui pénètre dans le substrat de la première surface à l'autre surface de façon à être exposé dans l'autre surface du substrat ; dans lequel :
le premier câblage est connecté au second câblage ; et
la surface exposée du second câblage est disposée sur une portion d'extrémité du substrat en vue en plan.

3. Dispositif de génération d'énergie thermoélectrique selon la revendication 1 ou 2, comprenant en outre :
un film métallique (5) qui est prévu pour refroidir le substrat et qui est formé autour d'une région où le circuit de stockage électrique et le premier câblage sur l'autre surface du substrat sont disposés ; dans lequel :
l'ailette de rayonnement thermique couvre également une limite entre le premier câblage et le film métallique en vue en plan.

4. Appareil électronique portable équipé du dispositif de génération d'énergie thermoélectrique selon l'une quelconque des revendications 1 à 3, dans lequel :
l'appareil électronique portable comprend un élément qui génère de la chaleur en consommant de l'énergie électrique ; et
un côté haute température de l'élément de conversion thermoélectrique inclus dans le dispositif de génération d'énergie thermoélectrique est disposé pour faire face à l'élément.
